# EUROPÄISCHE PATENTANMELDUNG

(11) **EP 1 244 213 A2**
(43) Veröffentlichungstag der Anmeldung: **25.09.2002**
(21) Anmeldenummer: 01130403.7
(22) Anmeldetag: 20.12.2001
(51) Int. Cl.: H03H 11/24

(54) **Steuerbares Dämpfungsglied sowie ein Verfahren und Verwendung hierzu**

(30) Priorität: 22.03.2001 DE 10114037
(71) Anmelder: ROBERT BOSCH GMBH, 70442 Stuttgart (DE)
(72) Erfinder: Kasper, Erich, Prof., 89284 Pfaffenhofen (DE); Schier, Erich, 71717 Beilstein (DE); Ulm, Markus, 70197 Stuttgart (DE); Walter, Thomas, 71272 Renningen (DE); Mueller-Fiedler, Roland, 71229 Leonberg (DE)

(57) **Zusammenfassung**

Ein steuerbares Dämpfungsglied wird mittels einer koplanaren Leitung ausgebildet, die auf einem Substrat mit HalbleiterMaterial (4) aufgebracht ist. Zwischen der Metallisierung (1, 2, 3), der koplanaren Leitung und dem HalbleiterMaterial (4) wird eine Steuerspannung (7) zur Einstellung der gewünschten Dämpfung angelegt.

## Beschreibung

### Stand der Technik

Die Erfindung geht aus von einem steuerbaren Dämpfungsglied. Steuerbare Dämpfungsglieder stellen wichtige Komponenten in Mikro- und Millimeterwellenschaltungen zur Leistungsanpassung von Pegeln dar. Eine wichtige Aufgabenstellung ist die Regelung der Sendeleistung einer Antenne. Solche steuerbaren Dämpfungsglieder können mit pin-Dioden oder MESFETs, deren "On"-Widerstand über eine Spannung moduliert wird, in einer Hochfrequenzschaltung realisiert werden.

### Vorteile der Erfindung

Mit den Maßnahmen des Anspruchs 1 sind steuerbare Dämpfungsglieder realisierbar, die einen sehr einfachen Aufbau haben und in Millimeterwellenschaltungen einfach integriert werden können. Im Gegensatz zu steuerbaren Dämpfungsgliedern nach dem Stand der Technik treten bei der erfindungsgemäßen Realisierung folgende Nachteile nicht auf: Die Herstellung von pin-Dioden und MESFETs erfordert komplexe Prozeßschritte. Die Integration solcher Bauelemente in Millimeterwellenschaltungen ist insbesondere bei hohen Frequenzen mit technologischen Schwierigkeiten und Kosten verbunden. Dies gilt insbesondere für Antennenarrays, bei denen gegebenenfalls einzelne Spalten getrennt gedämpft werden sollen und daher mehrere aktive Bauelemente nötig sind. Zudem weisen aktive Bauelemente eine verglichen mit der Erfindung höhere Einfügungsdämpfung auf.

Die Erfindung beruht auf folgenden Erkenntnissen:
Die Dämpfung von koplanaren Leitungen auf HalbleiterSubstraten, insbesondere Silizium, hängt von der Dichte beweglicher Ladungsträger primär an der Halbleiter-Oberfläche ab, d.h. niedrig dämpfende Leitungen erfordern hochohmige Substrate. Durch Modulation der Konzentration beweglicher Ladungsträger an der Halbleiter-Oberfläche kann die Leitungsdämpfung eingestellt werden. Dies kann durch Anlegen einer elektrischen Spannung zwischen Leitung und Substrat erfolgen [1] (Metal-Insulator-Semiconductor-Effekt). Somit kann dieser Effekt für steuerbare Dämpfungsglieder ausgenutzt werden. Die erfindungsgemäßen Strukturen zeichnen sich durch einen sehr einfachen Aufbau und insbesondere die einfache Integrierbarkeit in Millimeterwellenschaltungen aus.

Insbesondere ist es möglich, die von einer Antenne abgestrahlte und über eine Leitung zugeführte Mikrowellenoder Millimeterwellenleistung durch Variation der Leitungsdämpfung zu steuern. Eine Leistungsregulierung der eigentlichen Millimeterwellenquelle oder ein weiteres aktives Bauelement, pin-Diode oder MESFET, entfällt. Wird eine Antenne sowohl im Sende- als auch im Empfangszweig genutzt, so macht es die geringe Einfügedämpfung möglich, das Dämpfungsglied in die gemeinsame Zuleitung zu integrieren. Da die Kosten für das einzelne Dämpfungsglied relativ gering sind, ist auch eine Anwendung in Antennenarrays vorteilhaft, bei denen einzelne Spalten und/oder Zeilen getrennt gedämpft werden sollen.

Besonders vorteilhaft ist der Einsatz der Erfindung für die Leistungsregulierung bei den Systemen ACC (Automotive Cruise Control) oder SRR (Short Range Radar). Zulassungsprobleme durch zuviel abgestrahlte Leistung können durch die erfindungsgemäßen Lösungen umgangen werden.

### Zeichnungen

Anhand der Zeichnungen werden Ausführungsbeispiele der Erfindung erläutert. Es zeigen
Figur 1 ein steuerbares Dämpfungsglied mit der Steuerspannung zwischen der Metallisierung der koplanaren Leitung und einer Rückseitenmetallisierung des Substrates,
Figur 2 ein steuerbares Dämpfungsglied mit einer Steuerspannung zwischen Signalleitung und den Massebelägen der koplanaren Leitung,
Figur 3 ein steuerbares Dämpfungsglied mit der Steuerspannung zwischen der Metallisierung der koplanaren Leitung und einem Kontakt zu einer n-dotierten Wanne im p-dotierten Halbleitermaterial,
Figur 4 einen Einsatz des steuerbaren Dämpfungsgliedes in der Zuleitung einer Antenne.

### Beschreibung von Ausführungsbeispielen

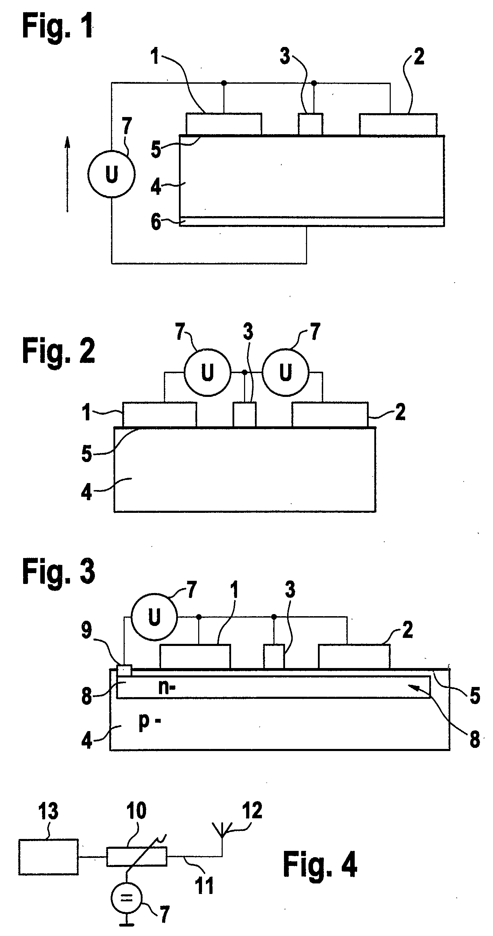

Die Figuren 1, 2 und 3 zeigen eine koplanare Leitung, bestehend aus zwei äußeren Massebelägen 1, 2 und einer Signalleitung 3 dazwischen auf einem hochohmigen Halbleitermaterial (Halbleiter-Substrat) 4, z.B. SiO₂ oder Si₃N₄. Nachfolgend werden die äußeren Massebeläge 1, 2 und die Signalleitung 3 zusammen als Metallisierung der koplanaren Leitung bezeichnet. Zwischen der Metallisierung 1, 2, 3 und dem Halbleiter-Substrat 4 ist eine dünne Isolierschicht 5 vorgesehen. Die Unterseite des HalbleiterSubstrats 4 ist bei Figur 1 mit einer Rückseitenmetallisierung 6 versehen. Diese Rückseitenmetallisierung 6 besteht beispielsweise aus Aluminium.

Durch Anlegen einer Spannung zwischen der Metallisierung 1, 2, 3 der koplanaren Leitung über entsprechende Kontakte läßt sich die Dämpfung der koplanaren Leitung beeinflussen und damit ein steuerbares Dämpfungsglied realisieren. Durch die angelegte Spannung werden an der Halbleiter-Oberfläche gemäß der wohlverstandenen Physik einer Metal-Insulator-Semiconductor-Struktur [1] bewegliche Ladungsträger generiert bzw. moduliert. Somit ist die Dämpfung der elektromagnetischen Welle der koplanaren Leitung durch eine solche Steuerspannung beeinflußbar.

Im Ausführungsbeispiel gemäß Figur 1 ist diese Steuerspannung 7 zwischen der Metallisierung 1, 2, 3 und der Rückseitenmetallisierung 6 vorgesehen. Im Ausführungsbeispiel gemäß Figur 2 ist diese Steuerspannung 7 jeweils zwischen einem äußeren Massebelag 1 bzw. 2 und der Signalleitung 3 vorgesehen. Im Ausführungsbeispiel gemäß Figur 3 ist in einem p-dotierten Substrat 4 eine n-dotierte Wanne 8 vorgesehen. Die Steuerspannung 7 liegt hier zwischen der Metallisierung 1, 2, 3 und einem Kontakt 9 zur n-dotierten Wanne. Natürlich kann die Dotierung auch umgekehrt sein, d.h. eine p-dotierte Wanne 8 in einem n-dotierten Substrat 4.

Es können auch mehrere Signalleitungen zwischen Massebelägen angeordnet sein, entsprechend dem Aufsatz "Open-end length extension in coplanar waveguide coupled line DC blocks with finite ground planes von S. Uysal (http: //www.eng.nus.edu.sg/EResnews/9808/p11.html). Zur steuerbaren Dämpfung ist dann mindestens eine dieser Signalleitungen an die Steuerspannung 7 anzuschließen.

Bei welcher Steuerspannung das Minimum der Dämpfung liegt, hängt von der Wahl der Metallisierung des Halbleiter-Materials und der Isolierschicht ab. So kann z.B. durch in der Isolierschicht vorhandene feste Ladungen (Elektred) die Schwellenspannung beträchtlich, z.B. um 30 V, verschoben werden. Somit sind auch Strukturen realisierbar, die bei 0 V stark dämpfen und bei 30 V ihr Dämpfungsminimum zeigen.

Das steuerbare Dämpfungsglied 10 der Erfindung eignet sich vorteilhaft für den Einsatz in der Zuleitung (Speisung) 11 einer Antenne 12 (Figur 4), die sowohl für Sende- als auch für Empfangsbetrieb nutzbar ist und von einer Hochfrequenzschaltung 13 aus betrieben wird. Insbesondere wenn die Zuleitung 11 als koplanare Leitung ausgebildet ist, eventuell als Bestandteil der Hochfrequenzschaltung 13, sind keine zusätzlichen steuerbaren, insbesondere aktiven Dämpfungsglieder zur Begrenzung der von der Antenne 12 abgestrahlten Leistung erforderlich. Es muß lediglich die sowieso vorhandene koplanare Leitung mit der Steuerspannung 7 beaufschlagt werden.

Eine weitere vorteilhafte Anwendung des erfindungsgemäßen Dämpfungsglieds ist in einem Antennenarray, bei dem die einzelnen Spalten und/oder Zeilen getrennt gedämpft werden sollen. In der Zuleitung jeder getrennt zu dämpfenden Spalte und/oder Zeile kann sich das erfindungsgemäße Dämpfungsglied befinden.

Die Erfindung eignet sich vorteilhaft zur Leistungsregulierung bei ACC (Automotive Cruise Control) oder SRR (Short Range Radar) -Systemen, um die abgestrahlte Leistung der Antennen zu begrenzen.

### Literatur:

[1] S.M.Sze: Physics of Semiconductor Devices, Second Edition, John Wiley and Sons, 1981, Seiten 362 bis 379.

## Patentansprüche

1. Steuerbares Dämpfungsglied unter Verwendung einer koplanaren Leitung, die auf einem Substrat mit Halbleiter-Material (4) aufgebracht ist, wobei zwischen der Metallisierung (1, 2, 3) der koplanaren Leitung und dem Halbleiter-Material (4) des Substrates eine die Dämpfung der koplanaren Leitung bestimmende Steuerspannung (7) angelegt ist.

2. Steuerbares Dämpfungsglied nach Anspruch 1, **dadurch gekennzeichnet, daß** die Steuerspannung (7) zwischen der Metallisierung (1, 2, 3) der koplanaren Leitung und einer Rückseitenmetallisierung (6) des Halbleiter-Materials (4) vorgesehen ist.

3. Steuerbares Dämpfungsglied nach Anspruch 1, **dadurch gekennzeichnet, daß** die Steuerspannung (7) zwischen der/den Signalleitung/en (3) und den Massebelägen (1, 2) der koplanaren Leitung vorgesehen ist.

4. Steuerbares Dämpfungsglied nach Anspruch 1, **dadurch gekennzeichnet, daß** die Steuerspannung (7) zwischen der Metallisierung (1, 2, 3) der koplanaren Leitung und einem Kontakt (9) zu einer n-dotierten Wanne (8) im Halbleiter-Material des Substrats (4), welches p-dotiert ist, vorgesehen ist.

5. Steuerbares Dämpfungsglied nach Anspruch 1, **dadurch gekennzeichnet, daß** die Steuerspannung (7) zwischen der Metallisierung (1, 2, 3) der koplanaren Leitung und einem Kontakt (9) zu einer p-dotierten Wanne (8) im Halbleiter-Material des Substrats (4), welches n-dotiert ist, vorgesehen ist.

6. Steuerbares Dämpfungsglied nach einem der Ansprüche 1 bis 5, **dadurch gekennzeichnet, daß** zwischen der Metallisierung (1, 2, 3) der koplanaren Leitung und dem Halbleiter-Material des Substrates (4) eine Isolierschicht (5) vorgesehen ist.

7. Steuerbares Dämpfungsglied nach Anspruch 6, **dadurch gekennzeichnet, daß** das Dämpfungsminimum und/oder - maximum in Abhängigkeit der in der Isolierschicht (5) vorhandenen festen Ladungen vorgegeben ist.

8. Einrichtung mit einem steuerbaren Dämpfungsglied nach einem der Ansprüche 1 bis 7, **dadurch gekennzeichnet, daß** das Dämpfungsglied in die Zuleitung einer Antenne (12) geschaltet ist, die sowohl für Sende- und Empfangsbetrieb nutzbar ist.

9. Antennenarray mit Maßnahmen zur unterschiedlichen Dämpfung von Spalten und/oder Zeilen des Arrays, wobei zur getrennten Dämpfung von Spalten und/oder Zeilen steuerbare Dämpfungsglieder nach einem der Ansprüche 1 bis 7 vorgesehen sind.

10. Verfahren zur Steuerung der Dämpfung einer koplanaren Leitung, die auf einem Substrat (4) mit Halbleiter-Material aufgebracht ist, wobei eine Modulation der Konzentration beweglicher Ladungsträger an der Halbleiter-Oberfläche mittels einer Steuerspannung (7) zwischen der Metallisierung (1, 2, 3) der koplanaren Leitung und dem Substrat (4) vorgenommen wird.

11. Dämpfungsglied nach einem der Ansprüche 1 bis 7, Einrichtung nach Anspruch 8, Antennenarray nach Anspruch 9 oder Verfahren nach Anspruch 10 zur Leistungsregulierung bei ACC (Automotive Cruise Control) oder SRR (Short Range Radar) -Systemen.
